# EUROPÄISCHE PATENTSCHRIFT

(11) **EP 3 128 528 B1**
(45) Veröffentlichungstag und Bekanntmachung des Hinweises auf die Patenterteilung: **08.04.2020**
(21) Anmeldenummer: 16170113.1
(22) Anmeldetag: 18.05.2016
(51) Int. Cl.: H01H 27/00, F16P 3/08, H03K 17/945

(54) **MODULANORDNUNG**
MODULE ASSEMBLY
AGENCEMENT DE MODULE

(30) Priorität: 06.08.2015 DE 102015112990
(43) Veröffentlichungstag der Anmeldung: 08.02.2017
(73) Patentinhaber: EUCHNER GmbH + Co. KG, 70771 Leinfelden-Echterdingen (DE)
(72) Erfinder: Hörtling, Markus, 70771 Leinfelden-Echterdingen (DE); Kraus, Matthias, 73760 Ostfildern (DE); Rothenburg, Jens, 72622 Nürtingen (DE); Schmid, Dominik, 72663 Großbettlingen (DE); Schmid, Monika, 72663 Großbettlingen (DE); Siefert, Timo, 70771 Leinfelden-Echterdingen (DE)
(74) Vertreter: Ruckh, Rainer Gerhard

(56) Entgegenhaltungen:
- EP-A1- 2 645 393
- EP-A2- 2 650 993
- WO-A1-2015/083143
- US-B1- 6 310 305
- Euchner Gmbh: "Betriebsanleitung Sicherheitssysteme", , 3. Januar 2015 (2015-01-03), XP055278921, Gefunden im Internet: URL:https://www.euchner.de/portals/0/siriu smedia/pim/data/210579.pdf [gefunden am 2016-06-08]

## Beschreibung

Die Erfindung betrifft eine Modulanordnung.

Generell umfasst eine derartige Modulanordnung Elektronikmodule in Form von einem Grundmodul und einem oder mehreren Submodulen, die über Anschlussmodule in Form von Steckern oder Buchsen miteinander kontaktiert werden können, um so ein Gesamtsystem mit einer bestimmten Funktionalität auszubilden.

Insbesondere können derartige Modulanordnungen Sicherheitssysteme, das heißt in dem Bereich der Sicherheitstechnik eingesetzte Systeme bilden.

Ein Beispiel für ein derartiges Sicherheitssystem ist ein Sicherheitszuhaltesystem.

Dieses Sicherheitszuhaltesystem gewährleistet ein sicheres Zuhalten von beweglich trennenden Schutzeinrichtungen, insbesondere Schutztüren und somit einen gesicherten Zugang zu eingezäunten sicherheitskritischen Gefahrenbereichen. Das Sicherheitszuhaltesystem umfasst ein Zuhaltemodul, an welchem ein Griffmodul angeordnet ist. Diese Module dienen zum sicheren Zuhalten der Schutztür. Der Türdrücker des Griffmoduls kann durch Federkraft in zugehaltener Stellung gehalten werden und durch Magnetkraft entsperrt werden. Alternativ kann der Türdrücker durch Magnetkraft in zugehaltener Stellung gehalten werden und durch Federkraft entsperrt werden.

Eine Modulanordnung zur Ausbildung eines derartigen Sicherheitszuhaltesystems ist aus der DE 10 2015 101 133.6 bekannt.

Bei dieser Modulanordnung ist ein Zuhaltemodul mit einer drehinvarianten Ausbildung von Anschlussmodulen vorgesehen, so dass das Zuhaltemodul in zwei um 180° versetzten Drehpositionen innerhalb der Modulanordnung angeordnet werden kann, wodurch das Griffmodul einer Schutztüre wahlweise links oder rechts am Zuhaltemodul angeordnet werden kann. Damit kann dieses Sicherheitszuhaltesystem für entsprechend unterschiedliche Schutztürtypen mit links- oder rechtsseitig angeordneten Griffmodulen eingesetzt werden.

Die EP 2 645 393 A1 betrifft einen Sicherheitsschalter mit einem zwei Aufnahmen aufweisenden Gehäuse und einem eine Zunge aufweisenden Aktuator. Weiterhin ist am Aktuator ein erster RFID Sensor angeordnet. Am Rand jeder Aufnahme des Gehäuses ist ein zweiter RFID Sensor angeordnet. Zur Generierung eines Sicherheitsausgangssignals kann die Zunge des Aktuators wahlweise in eine der Aufnahmen eingesteckt werden. Das Sicherheitsausgangssignal wird dann generiert, wenn bei Einstecken in die Aufnahme die mechanische Codierung der Zunge erkannt wird und wenn mit dem zweiten RFID Sensor am Gehäuse die kodierten Signale des ersten RFID Sensors vom Aktuator als gültig erkannt werden.

Die WO 2015/083143 A1 betrifft einen modular aufgebauten Sicherheitsschalter. Dieser weist ein Gehäuseteil und ein Kopfteil mit einem Schließmechanismus auf. Das Kopfteil kann in unterschiedlichen Orientierungen am Gehäuseteil montiert werden.

Die EP 2 650 993 A2 betrifft eine Anordnung zum Installieren von Geräten der Gebäudesystemtechnik, mit einem Gehäuse, das eine Steuereinrichtung zur Ausführung einer elektronischen Funktion beinhaltet, und mit einem Basismodul, das zur Befestigung des Gehäuses für eine vorbestimmte Montagesituation ausgebildet ist. Das Gehäuse und das Basismodul sind für eine feste aber lösbare Verbindung ausgebildet, sodass in Abhängigkeit von der Montagesituation das Gehäuse mit einem an die jeweilige Montagesituation angepassten Basismodul verbindbar ist. Das Basismodul ist als verschließbarer Installationskasten ausgebildet, wobei der Installationskasten eine Busanschlussleitung zum Anschluss an ein Bussystem aufweist. Der Installationskasten weist eine Sammelschiene zum Anschluss elektrischer Leitungen auf.

Die US 6 310 305 B1 betrifft eine Sicherheitsschalteranordnung mit einer am Rahmen einer Tür angeordneten Schaltereinheit und Schließeinheit. An einer Tür befindet sich ein Aktuator. Die Schließeinheit weist zwei Schlitze zur Aufnahme des Aktuators auf. Wird mit der Schließeinheit das Einführen des Aktuators in einen der Schlitze erkannt, löst die Schaltereinheit ein Signal zum Betrieb einer Maschine aus.

In Euchner GmbH: "Betriebsanleitung Sicherheitssysteme", 3. Januar 2015 (2015-01-03), XP 055278921 sind Sicherheits-Inhaltssysteme beschrieben.

Der Erfindung liegt die Aufgabe zugrunde, mit geringem konstruktivem Aufwand die Funktionalität einer Modulanordnung der eingangs genannten Art zu erweitern.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft eine Modulanordnung mit einem Grundmodul und wenigstens einem Submodul, wobei das Grundmodul wenigstens zwei Anschlussmodule aufweist. Das Submodul ist mit einem Anschlussmodul wahlweise an einem der Anschlussmodule des Grundmoduls kontaktierbar und somit in unterschiedlichen Drehpositionen am Grundmodul anbringbar. Im Grundmodul sind Erfassungsmittel zur Erfassung der Drehposition des an diesem angebrachten Submoduls vorgesehen. Erfindungsgemäß bildet die Modulanordnung ein Sicherheitssystem aus, wobei das Grundmodul von einem Zuhaltemodul (2) oder einem Erweiterungsmodul (4) gebildet ist. Das Zuhaltemodul (2) weist eine Aufnahme (2a) für ein Griffmodul (3) auf. In zwei unterschiedlichen Drehstellungen des Zuhaltemoduls (2) ist das Griffmodul (3) wahlweise links- oder rechtsseitig zu diesem orientiert anschließbar.

Bei der erfindungsgemäßen Modulanordnung wird eine hohe Funktionalität dadurch erreicht, dass das oder die Submodule in verschiedenen Drehpositionen am Grundmodul angebracht werden können und dort mit diesem Grundmodul eine funktionsfähige Einheit bilden. Dabei kann das Grundmodul selbst in unterschiedlichen Orientierungen in einer übergeordneten Modulstruktur eingebaut werden, wobei je nach Orientierung des Grundmoduls die Orientierung der Submodule am Grundmodul geeignet gewählt werden kann.

Wird beispielsweise in einer Applikation eine bestimmte Absolutorientierung eines Submoduls gefordert, beispielsweise bedingt durch eine auf dem Submodul vorhandene Reihenstruktur von Bedienelementen, die fest vorgegeben ist, so kann diese Anforderung für eine Modulanordnung mit einem Grundmodul in unterschiedlichen Orientierungen erfindungsgemäß dadurch realisiert werden, dass auch die Orientierung des Submoduls am Grundmodul an die Orientierung des Grundmoduls angepasst wird, um so immer die gewünschte Anordnung der Bedienelemente beizubehalten.

Ein wesentlicher Aspekt der Erfindung besteht darin, dass im Grundmodul Erfassungsmittel zur Orientierung des oder eines Submoduls am Grundmodul vorgesehen sind.

Besonders vorteilhaft wird mit den Erfassungsmitteln die Orientierung des Submoduls am Grundmodul dadurch bestimmt, dass erfasst wird, in welches der Anschlussmodule des Grundmoduls das Anschlussmodul eingeführt ist.

Die Funktionalität der Modulanordnung wird vorteilhaft dadurch noch erweitert, dass mit den Erfassungsmitteln eine Typerkennung des Submoduls erfolgt.

Durch die mit den Erfassungsmitteln erfassbare Orientierung und gegebenenfalls auch noch des Typs des Submoduls am Grundmodul wird die Funktionssicherheit der gesamten Modulanordnung erheblich erhöht, da Manipulationen durch eine falsche Anordnung von Submodulen am Grundmodul selbsttätig erfasst werden können.

Bei Erkennung einer derartigen Manipulation können vorteilhaft selbsttätig geeignete Gegenmaßnahmen eingeleitet werden. Beispielsweise kann der Betrieb der Modulanordnung nur dann freigegeben werden, wenn keine derartige Manipulation vorliegt.

Die Funktionalität der Modulanordnung kann generell dadurch erweitert sein, dass am Grundmodul mehrere Submodule kontaktierbar sind, wobei das Grundmodul für den Anschluss jedes Submoduls jeweils wenigstens zwei Anschlussmodule aufweist.

Besonders vorteilhaft sind dann am Grundmodul separate Steckplätze mit mehreren, vorzugweise zwei Anschlussmodulen vorgesehen, an welchen jeweils ein Submodul in unterschiedlichen Orientierungen kontaktiert werden kann.

Gemäß einer zweckmäßigen Ausgestaltung der Erfindung weist das Grundmodul für den Anschluss des oder jedes Submoduls zwei Anschlussmodule derart auf, dass die Submodule in zwei um 180° versetzte Drehpositionen am Grundmodul anbringbar sind.

Diese Ausführungsform ist besonders vorteilhaft für Modulanordnungen einsetzbar, bei denen das Grundmodul selbst in um 180° zueinander gedrehten Drehpositionen eingesetzt werden kann. Je nach Drehposition des Grundmoduls wird dann die Drehposition des oder jedes Submoduls am Grundmodul so gewählt, dass beispielsweise Anordnungen von Bedienelementen auf dem oder den Submodulen invariant bezüglich der Drehung des Grundmoduls sind.

Gemäß einer konstruktiv vorteilhaften Ausgestaltung der Erfindung weist das Grundmodul als Bestandteil der Erfassungsmittel eine Auswerteelektronik auf, mittels derer aus einem Submodul eingelesene Informationen ausgewertet werden.

Zum Einlernen von Informationen aus einem Submodul, die dort in Speicherelementen gespeichert sein können, wird vorteilhaft eine serielle Schnittstelle verwendet, die in den Anschlussmodulen des Grundmoduls und des Submoduls integriert ist.

Besonders vorteilhaft wird in einem Lernprozess die Drehposition und der Typ des oder jedes am Grundmodul angeordneten Submoduls im Grundmodul eingelernt und gespeichert.

Diese eingelernten Werte werden dann für den Betrieb der Modulanordnung verwendet und können vorzugsweise nur durch einen Werkreset gelöscht werden. Damit ist gewährleistet, dass eine gültig eingelernte Konfiguration von Grundmodulen und zugeordneten Submodulen sicher erhalten bleibt.

Erfindungsgemäß wird die erfindungsgemäße Modulanordnung im Bereich der Sicherheitstechnik als Sicherheitssystem eingesetzt.

Dort besteht eine vorteilhafte Einsatzmöglichkeit darin, dass die Modulanordnung ein Sicherheitszuhaltesystem ausbildet, welches ein Zuhaltemodul mit einer Aufnahme für ein Griffmodul aufweist. In zwei unterschiedlichen Drehstellungen des Zuhaltemoduls ist das Griffmodul wahlweise links- oder rechtsseitig zu diesem orientiert anschließbar.

Diese Konfiguration kann somit sowohl für Schutztüren oder dergleichen genutzt werden, bei welchen das Griffmodul links- oder rechtsseitig an der Schutztür angeordnet ist. Je nachdem welcher Typ von Schutztür eingesetzt wird, ist innerhalb der Modulanordnung das Zuhaltemodul in einer ersten Drehposition oder in einer bezüglich dieser um 180° gedrehten Drehposition angeordnet, so dass eine Aufnahme am Zuhaltemodul links oder rechts an diesem angeordnet ist und das jeweilige Griffmodul aufnehmen kann.

Bei dieser Modulanordnung kann das Grundmodul von einem an dem Zuhaltemodul anbringbaren Erweiterungsmodul gebildet sein. Alternativ kann das Grundmodul vom Zuhaltemodul selbst gebildet sein.

Die Erfindung wird im Folgenden anhand der Zeichnungen erläutert. Es zeigen:
- Figur 1:: Ausführungsbeispiel einer ein Sicherheitszuhaltesystem bildenden Modulanordnung in einer ersten Anordnung von Modulen.
- Figur 2:: Modulanordnung gemäß Figur 1 in einer zweiten Anordnung der Module.
- Figur 3a-c:: Darstellung eines Grundmoduls mit darauf angeordnetem Submodul in unterschiedlichen Drehpositionen.
- Figur 4a-c:: Darstellungen gemäß den Figuren 3a-c bei vom Grundmodul abgelöstem Submodul.

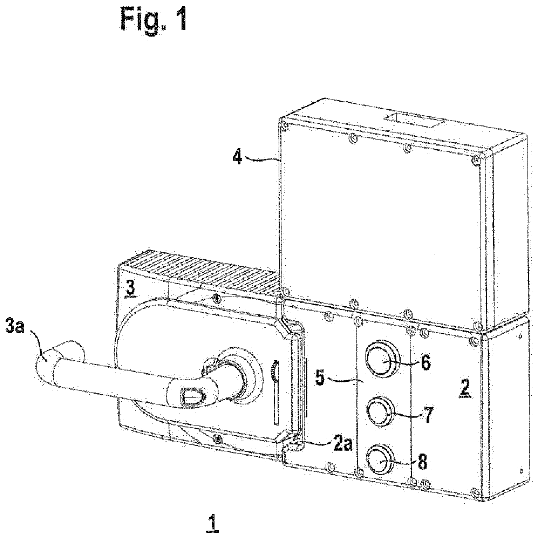

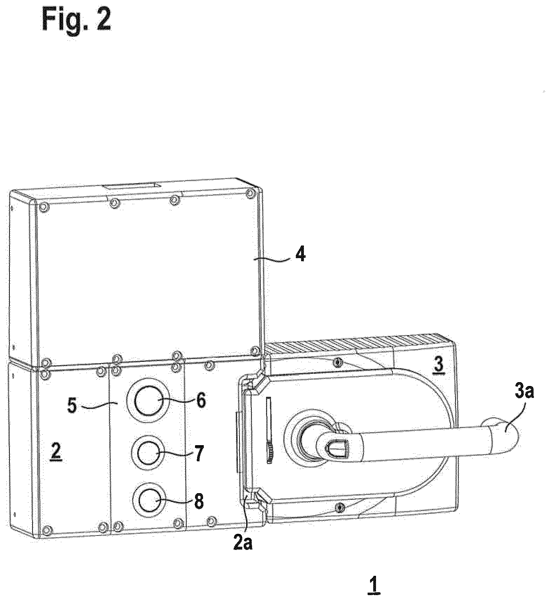

Die Figuren 1 und 2 zeigen ein Ausführungsbeispiel der erfindungsgemäßen Modulanordnung 1 in Form eines Sicherheitszuhaltesystems. Das Sicherheitszuhaltesystem gewährleistet ein sicheres Zuhalten einer trennenden Schutzeinrichtung, wie zum Beispiel einer Schutztür. Die Modulanordnung 1 umfasst ein Zuhaltemodul 2, welches stationär an einem Rahmen oder dergleichen angeordnet ist, sowie ein an der Schutztür angeordnetes Griffmodul 3 mit einem Türdrücker 3a, welches mit der Schutztür bewegt werden kann. Das Zuhaltemodul 2 weist eine Aufnahme 2a auf, in welche das Griffmodul 3 bei geschlossener Schutztür eingeführt ist. Das Zuhaltemodul 2 hält die Schutztür sicher im geschlossenen Zustand und bewirkt somit eine Sicherung zu einem Gefahrenbereich an einer Maschine oder dergleichen.

Wie die Figuren 1 und 2 zeigen, kann das Zuhaltemodul 2 in zwei um 180° gegeneinander gedrehten Drehpositionen eingesetzt werden. In der ersten Drehposition (Figur 1) liegt die Aufnahme 2a links am Zuhaltemodul 2, so dass in diesem Fall ein rechtsseitig an einer Schutztür angeordnetes Griffmodul 3 in Eingriff mit dem Zuhaltemodul 2 gebracht werden kann. In der zweiten Drehposition (Figur 2) liegt die Aufnahme 2a rechts am Zuhaltemodul 2, so dass in diesem Fall ein linksseitig an einer Schutztür angeordnetes Griffmodul 3 in Eingriff mit dem Zuhaltemodul 2 gebracht werden kann.

Zur Erweiterung der Funktionalität kann über nicht dargestellte Anschlussmodule ein Erweiterungsmodul 4 am Zuhaltemodul 2 angeschlossen werden. Am Zuhaltemodul 2 als Grundmodul ist ein Submodul 5 angeschlossen. Das Zuhaltemodul 2, das Erweiterungsmodul 4 und das Submodul 5 sind über ein Datenbussystem verbunden.

Je nach Drehrichtung des Zuhaltemoduls 2 ist auch das Submodul 5 in zwei um 180° gegeneinander gedrehten Drehpositionen am Zuhaltemodul 2 angeschlossen.

Das Submodul 5 weist eine Reihenanordnung von Bedienelementen auf, nämlich einen Not-Aus-Taster 6 und zwei Tasten 7, 8 durch deren Bedienung bestimmte Funktionen des Sicherheitszuhaltesystems ausgelöst werden. Mit dem Not-Aus-Taster 6 kann beispielsweise der Betrieb einer gefahrbringenden Maschine gestoppt werden. Mit den Tasten 7, 8 können spezifische Bedienfunktionen des Sicherheitszuhaltesystems realisiert werden. Wie aus den Figuren 1 und 2 ersichtlich, ist die Orientierung der Bedienelemente unabhängig von der Drehposition des Zuhaltemoduls 2.

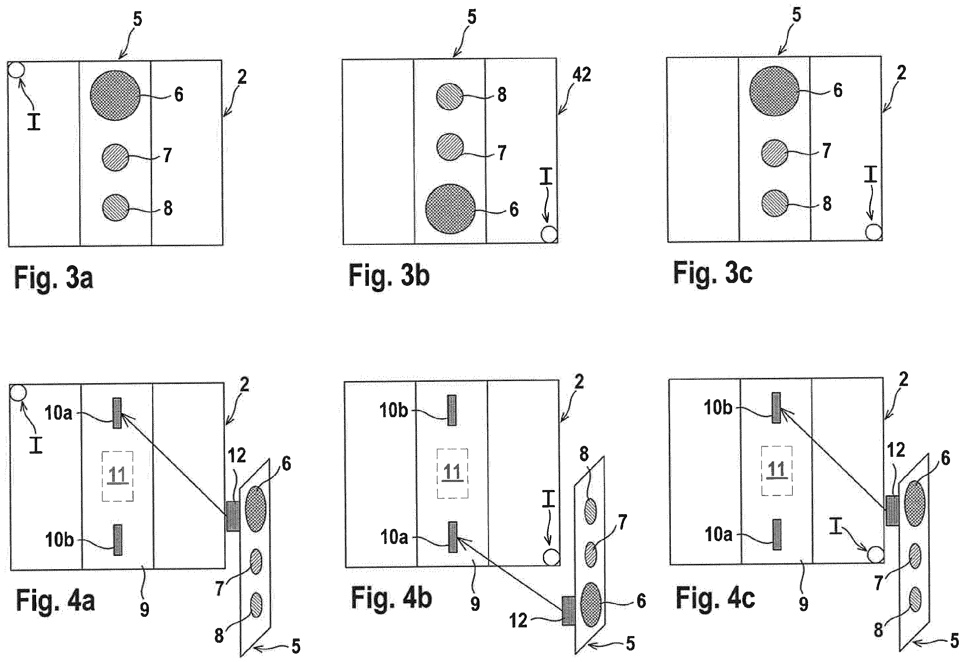

Die Figuren 3a-c zeigen unterschiedliche Drehpositionen des Grundmoduls, das heißt des Zuhaltemoduls 2 mit darauf angeordneten Submodulen 5, wobei die einzelnen Drehpositionen den Übergang von der Anordnung gemäß Figur 1 in die Anordnung gemäß Figur 2 zeigen. Die Figuren 4a-c zeigen dieselben Drehpositionen wie die Figuren 3a-c, jedoch bei vom Grundmodul abgenommenen Submodulen 5.

Wie aus den Figuren 4a-c ersichtlich, ist an der Oberseite des Gehäuses des Grundmoduls ein Steckplatz 9 vorgesehen, der sich in Form einer Leiste über die gesamte Länge des Gehäuses erstreckt. Auf diesem Steckplatz 9 sind als Anschlussmodule zwei identisch ausgebildete Buchsen 10a, 10b angeordnet. Die Buchsen 10a, 10b sind an gegenüberliegenden Randbereichen des Steckplatzes 9 angeordnet. Dabei verlaufen die Längsachsen entlang einer die Symmetrieachse des Steckplatzes 9 bildenden Geraden. Die Buchsen 10a, 10b sind an eine im Gehäuse des Grundmoduls angeordnete Auswerteelektronik 11 angeschlossen.

Das Submodul 5 ist von einem flächigen quaderförmigen Körper gebildet, dessen Grundfläche der Fläche des Steckplatzes 9 des Grundmoduls entspricht. Auf der Oberseite des Submoduls 5 sind die Bedienelemente, das heißt der Not-Aus-Taster 6 und die Tasten 7, 8 angeordnet. Von der Unterseite des Submoduls 5 steht als Anschlussmodul ein Stecker 12 hervor, wobei der Stecker 12 in einem Randbereich der Unterseite des Submoduls 5 angeordnet ist. Der Stecker 12 bildet ein zu den Buchsen 10a, 10b des Grundmoduls korrespondierendes Anschlussmodul, das heißt der Stecker 12 kann wahlweise in eine der Buchsen 10a, 10b eingesteckt werden, um so eine elektrische Verbindung zwischen Grundmodul und Submodul 5 zu bilden. Dabei umfasst die elektrische Verbindung eine serielle Schnittstelle, die im vorliegenden Fall von einer I²C-Schnittstelle gebildet ist.

Weiterhin umfasst die serielle Schnittstelle eine Kommunikations-Schnittstelle. Über die I²C-Schnittstelle erfolgt die Erfassung des Typs und der Orientierung der angeschlossenen Einheit. Die Kommunikationsschnittstelle dient allgemein zum Datenaustausch zwischen den angeschlossenen Einheiten.

Alternativ zu der in den Figuren 4a-c dargestellten Ausführungsform können natürlich auch die Anschlussmodule des Grundmoduls als Stecker und das Anschlussmodul des Submoduls 5 als Buchse ausgebildet sein.

Im Submodul 5 ist weiterhin ein nicht dargestelltes Speicherelement vorgesehen, in welchem den Typ kennzeichnende Daten gespeichert sind. Vorzugsweise ist das Speicherelement als nicht flüchtiger Speicher ausgebildet. Weiterhin ist im Submodul 5 eine ebenfalls nicht dargestellte Elektronikeinheit zur Ansteuerung der Bedienelemente und zur Aufnahme 2a und Weiterleitung der mit den Bedienelementen generierten Signale vorgesehen.

In den Figuren 3a bis 3c beziehungsweise 4a bis 4c sind die einzelnen Drehpositionen des Grundmoduls und des Submoduls 5 dargestellt, die zur Überführung der Anordnung gemäß Figur 1 in die Anordnung gemäß Figur 2 erforderlich sind. Aus Gründen der Übersichtlichkeit ist in den Figuren 3a bis 3c beziehungsweise 4a bis 4c die Drehposition des Grundmoduls mit einer Markierung I gekennzeichnet.

Figur 3a und korrespondierend hierzu 4a entspricht der in Figur 1 dargestellten Anordnung des Grundmoduls und Submoduls 5, bei welcher das Zuhaltemodul 2 so orientiert ist, dass die Aufnahme 2a links liegt um ein rechtsseitig an der Schutztür angeordnetes Griffmodul 3 aufzunehmen. Bei dieser Anordnung ist der Stecker 12 des Submoduls 5 mit der Buchse 10a des Grundmoduls kontaktiert.

Zur Überführung in die Anordnung gemäß Figur 2, in welcher das Zuhaltemodul 2 so orientiert ist, dass die Aufnahme 2a rechts liegt, um ein linksseitig in der Schutztür angeordnetes Griffmodul 3 aufzunehmen, wird ausgehend von der Anordnung gemäß Figur 3a beziehungsweise 4a zunächst das Grundmodul mit dem darauf angeordneten Submodul 5 um 180° gedreht, wodurch die Anordnung gemäß Figur 3b beziehungsweise 4b erhalten wird.

Anschließend wird bei unveränderter Drehposition des Grundmoduls das Submodul 5 relativ zum Grundmodul um 180° gedreht, so dass dann, wie in Figur 3c beziehungsweise 4c dargestellt, der Stecker 12 des Submoduls 5 mit der Buchse 10b kontaktiert ist. Dies entspricht der Anordnung von Figur 2.

Durch die Drehbarkeit des Submoduls 5 relativ zum Grundmodul wird erreicht, dass sowohl bei der Anordnung gemäß Figur 1 als auch bei der Anordnung gemäß Figur 2 die Bedienelemente des Submoduls 5 dieselbe Anordnung derart aufweisen, dass immer der Not-Aus-Taster 6 oben liegt.

Die zulässigen Konfigurationen gemäß Figur 3a beziehungsweise 3c können dadurch im Grundmodul selbsttätig erkannt werden, dass im Grundmodul eine Drehrichtungserkennung des Submoduls 5 erfolgt. Diese Drehrichtungserkennung erfolgt dadurch, dass in der Auswerteelektronik 11 erfasst wird, in welche Buchse 10a oder 10b der Stecker 12 des Submoduls 5 eingesteckt ist.

Weiterhin erfolgt in der Auswerteelektronik 11 anhand der vom Speicherelement des Submoduls 5 eingelesenen Daten eine Typerkennung des Submoduls 5, so dass im Grundmodul erfasst werden kann, ob ein zulässiges Submodul 5 angeschlossen ist.

In einem Lernprozess werden die Drehpositionen des Submoduls 5 am Grundmodul und der Typ des Submoduls 5 eingelernt und in der Auswerteelektronik 11 gespeichert, so dass zulässige Konfigurationen des Grundmoduls und Submoduls 5, wie beispielsweise in den Anordnungen der Figuren 1 und 2 dargestellt, im Grundmodul hinterlegt sind. Diese Konfiguration ist nur mit einem Werkreset löschbar. Damit wird eine hohe Manipulationssicherheit derartiger Anordnungen erzielt.

### Bezugszeichenliste

- (1): Modulanordnung
- (2): Zuhaltemodul
- (2a): Aufnahme
- (3): Griffmodul
- (3a): Türdrücker
- (4): Erweiterungsmodul
- (5): Submodul
- (6): Not-Aus-Taster
- (7): Taste
- (8): Taste
- (9): Steckplatz
- (10a, b): Buchse
- (11): Auswerteelektronik
- (12): Stecker

## Patentansprüche

1. Modulanordnung (1) mit einem Grundmodul und wenigstens einem Submodul (5) wobei das Grundmodul wenigstens zwei Anschlussmodule aufweist, und wobei das Submodul (5) mit einem Anschlussmodul wahlweise an einem der Anschlussmodule des Grundmoduls kontaktierbar ist, **dadurch gekennzeichnet, dass** das Submodul (5) in unterschiedlichen Drehpositionen am Grundmodul anbringbar ist, dass im Grundmodul Erfassungsmittel zur Erfassung der Drehposition des an diesem angebrachten Submoduls (5) vorgesehen sind, und dass die Modulanordnung (1) ein Sicherheitssystem ausbildet, wobei das Grundmodul von einem Zuhaltemodul (2) oder einem dem Zuhaltemodul (2) zugeordneten Erweiterungsmodul (4) gebildet ist, wobei das Zuhaltemodul (2) eine Aufnahme (2a) für ein Griffmodul (3) aufweist, wobei in zwei unterschiedlichen Drehstellungen des Zuhaltemoduls (2) das Griffmodul (3) wahlweise links- oder rechtsseitig zu diesem orientiert anschließbar ist.

2. Modulanordnung nach Anspruch 1, **dadurch gekennzeichnet, dass** mit den Erfassungsmitteln die Drehposition des Submoduls (5) am Grundmodul dadurch bestimmt wird, dass erfasst wird, in welches der Anschlussmodule des Grundmoduls das Anschlussmodul eingeführt ist.

3. Modulanordnung nach einem der Ansprüche 1 oder 2, **dadurch gekennzeichnet, dass** mit den Erfassungsmitteln eine Typerkennung des Submoduls (5) erfolgt.

4. Modulanordnung nach einem der Ansprüche 1 bis 3, **dadurch gekennzeichnet, dass** am Grundmodul mehrere Submodule (5) kontaktierbar sind, wobei das Grundmodul für den Anschluss jedes Submoduls (5) jeweils wenigstens zwei Anschlussmodule aufweist.

5. Modulanordnung nach einem der Ansprüche 1 bis 4, **dadurch gekennzeichnet, dass** das Grundmodul für den Anschluss des oder jedes Submoduls (5) zwei Anschlussmodule derart aufweist, dass die Submodule (5) in zwei um 180° versetzte Drehpositionen am Grundmodul anbringbar sind.

6. Modulanordnung nach einem der Ansprüche 1 bis 5, **dadurch gekennzeichnet, dass** das Grundmodul als Bestandteil der Erfassungsmittel eine Auswerteelektronik (11) aufweist, mittels derer aus einem Submodul (5) eingelesene Informationen ausgewertet werden.

7. Modulanordnung nach einem der Ansprüche 1 bis 6, **dadurch gekennzeichnet, dass** die Anschlussmodule jeweils eine serielle Schnittstelle aufweisen, welche Bestandteil der Erfassungsmittel sind.

8. Modulanordnung nach einem der Ansprüche 1 bis 7, **dadurch gekennzeichnet, dass** in jedem Submodul (5) ein Speicherelement vorgesehen ist, in welchem Informationen über das Submodul (5) abgespeichert sind.

9. Modulanordnung nach einem der Ansprüche 1 bis 8, **dadurch gekennzeichnet, dass** in einem Lernprozess die Drehposition und der Typ des oder jedes am Grundmodul angeordneten Submoduls (5) im Grundmodul eingelernt und gespeichert werden.

10. Modulanordnung nach Anspruch 9, **dadurch gekennzeichnet, dass** die im Grundmodul eingelernten Daten des oder jedes Submoduls (5) nur über einen Werkreset oder einen Lernvorgang löschbar sind.

## Claims

1. Module assembly (1) with a base module and at least one sub-module (5), wherein the base module comprises at least two connection modules and wherein the sub-module (5) is contactable with a connection module selectably at one of the connection modules of the base module, **characterised in that** the sub-module (5) can be brought into different rotational positions at the based module, that detecting means for detection of the rotational position of the sub-module (5) mounted on the base module are provided in the base module and that the module assembly (1) forms a safety system, wherein the base module is formed by a retaining module (2) or an expansion module (4) associated with the retaining module (2), wherein the retaining module (2) has a receptacle (2a) for a grip module (3), wherein in two different rotational settings of the retaining module (2) the grip module (3) is connectible in an orientation selectably on the lefthand side or righthand side with respect thereto.

2. Module assembly according to claim 1, **characterised in that** the rotational position of the sub-module (5) at the base module is determined by the detecting means **in that** it is detected into which of the connecting modules of the base module the connecting module is introduced.

3. Module assembly according to one of claims 1 and 2, **characterised in that** a type recognition of the sub-module (5) is carried out by the detecting means.

4. Module assembly according to any one of claims 1 to 3, **characterised in that** several sub-modules (5) are contactable with the base module, wherein the base module has in each instance at least two connecting modules for the connection of each sub-module (5).

5. Module assembly according to any one of claims 1 to 4, **characterised in that** the base module has for the connection of the or each sub-module (5) two connecting modules of such a kind that the sub-modules (5) can be brought into two rotational positions of the base module offset by 180°.

6. Module assembly according to any one of claims 1 to 5, **characterised in that** the base module comprises, as a component of the detecting means, an electronic evaluating system (11) by means of which read-in data from a sub-module (5) are evaluated.

7. Module assembly according to any one of claims 1 to 6, **characterised in that** the connecting modules each have a serial interface which is a component of the detecting means.

8. Module assembly according to any one of claims 1 to 7, **characterised in that** a memory element in which data about the sub-module (5) are stored is provided in each sub-module (5).

9. Module assembly according to any one of claims 1 to 8, **characterised in that** the rotational position and the type of the or each sub-module (5) arranged at the base module are learnt in the base module in a learning process and stored.

10. Module assembly according to claim 9, **characterised in that** the data, which are learnt in the base module, of the or each sub-module (5) can be deleted only by way of a factory reset or a learning process.

## Revendications

1. Agencement de module ou modulaire (1) doté d'un module de base et d'au moins un sous-module (5), le module de base comportant au moins deux modules de raccordement et le sous-module (5) pouvant être mis en contact au choix avec un module de raccordement ou l'autre au niveau d'un des modules de raccordement du module de base, **caractérisé en ce que** le sous-module (5) peut être monté au module de base dans différentes positions de rotation, que des moyens de détection sont prévus dans le module de base pour détecter la position de rotation du sous-module (5) monté dessus et que l'agencement modulaire (1) forme un système de sécurité, le module de base étant formé par un module de verrouillage (2) ou un module d'extension (4) associé au module de verrouillage (2), le module de verrouillage (2) comportant un logement (2a) pour un module de préhension (3), le module de préhension (3) pouvant être raccordé à celui-ci au choix avec une orientation de côté gauche ou une orientation de côté droit, dans deux positions de rotation différentes du module de verrouillage (2).

2. Agencement modulaire selon la revendication 1, **caractérisé en ce que** la position de rotation du sous-module (5) au niveau du module de base est déterminée à l'aide de moyens de détection, **caractérisé en ce que** l'on détecte dans lequel des modules de raccordement du module de base le module de raccordement est introduit.

3. Agencement modulaire selon l'une quelconque des revendications 1 ou 2, **caractérisé en ce qu'**une identification de type du sous-module (5) est réalisée à l'aide des moyens de détection.

4. Agencement modulaire selon l'une quelconque des revendications 1 à 3, **caractérisé en ce que** plusieurs sous-modules (5) peuvent être mis en contact au niveau du module de base, le module de base comportant respectivement au moins deux modules de raccordement pour le raccordement de chaque sous-module (5).

5. Agencement modulaire selon l'une quelconque des revendications 1 à 4, **caractérisé en ce que** le module de base comporte deux modules de raccordement pour le raccordement du ou des sous-modules (5), de telle sorte que les sous-modules (5) puissent être montés au module de base dans deux positions de rotation décalées de 180°.

6. Agencement modulaire selon l'une quelconque des revendications 1 à 5, **caractérisé en ce que** le module de base comporte un système d'analyse électronique (11) faisant partie des moyens de détection, ledit système servant à analyser les informations entrées à partir d'un sous-module (5).

7. Agencement modulaire selon l'une quelconque des revendications 1 à 6, **caractérisé en ce que** les modules de raccordement comportent respectivement une interface série faisant partie des moyens de détection.

8. Agencement modulaire selon l'une quelconque des revendications 1 à 7, **caractérisé en ce qu'**un élément de mémoire dans lequel des informations sont mémorisées sur le sous-module (5) est prévu dans chaque sous-module (5).

9. Agencement modulaire selon l'une quelconque des revendications 1 à 8, **caractérisé en ce que** la position de rotation et le type de sous-module ou de sous-modules (5) disposés au niveau du modules de base sont programmés et mémorisés dans le module de base lors d'un processus d'apprentissage.

10. Agencement modulaire selon la revendication 9, **caractérisé en ce que** les données programmées dans le module de base du ou des sous-modules (5) peuvent uniquement être supprimées via une réinitialisation d'usine ou un processus d'apprentissage.
